# EUROPÄISCHE PATENTSCHRIFT

(11) **EP 3 162 443 B1**
(45) Veröffentlichungstag und Bekanntmachung des Hinweises auf die Patenterteilung: **18.12.2019**
(21) Anmeldenummer: 16194424.4
(22) Anmeldetag: 18.10.2016
(51) Int. Cl.: B01L 3/02, G01N 35/10, B01L 9/00, G01R 33/30, G01N 35/04

(54) **NADELFÜHRUNG MIT ZENTRIERUNG FÜR SEPTUM-PIERCING**
NEEDLE GUIDE FOR CENTERING OF SEPTUM PIERCING
GUIDE D'AIGUILLE POUR CENTRER LE PERÇAGE D'UN SEPTUM

(30) Priorität: 28.10.2015 DE 102015221024
(43) Veröffentlichungstag der Anmeldung: 03.05.2017
(73) Patentinhaber: Bruker BioSpin GmbH, 76287 Rheinstetten (DE)
(72) Erfinder: Hofmann, Martin, 76332 Bad Herrenalb (DE)
(74) Vertreter: Kohler Schmid Möbus Patentanwälte

(56) Entgegenhaltungen:
- EP-A1- 0 478 905
- EP-A1- 0 549 573
- US-A- 3 991 627
- US-A- 5 756 905

## Beschreibung

Die Erfindung betrifft eine Pipettiervorrichtung zur Entnahme von Probenflüssigkeit aus einem Probengefäß, das oberseitig mit einem Septum verschlossen ist, umfassend eine Pipettiernadel sowie eine Hilfskanüle zum Durchstechen des Septums, die zum axialen Durchführen der Pipettiernadel durch die Hilfskanüle ausgebildet ist.

Eine solche Pipettiervorrichtung ist etwa aus der Firmendruckschrift "Triathlon user manual" der Spark Holland B.V., Pieter de Keyserstraat 8, NL-7825 VE Emmen, Niederlande, vom April 2000 bekannt geworden.

### Hintergrund der Erfindung

Die vorliegende Erfindung betrifft allgemein den Bereich der Probenaufbereitung von flüssigen Proben in einem Probengefäß, insbesondere die Entnahme von Probenflüssigkeit aus einem Probengefäß oder das Einfüllen von Probenflüssigkeit in ein Probengefäß, wobei das Probengefäß oberseitig mit einem Septum verschlossen ist. Die Erfindung betrifft insbesondere die Aufbereitung von Proben, die zur Analyse mittels der NMR-Spektroskopie bestimmt sind. Die Anwendbarkeit der Erfindung ist jedoch nicht auf dieses Gebiet beschränkt.

Die NMR-Spektroskopie ist eine weit verbreitete Messmethode, mit der chemische Verbindungen analysiert werden können. Üblicherweise wird bei der NMR-Spektroskopie eine zu vermessende Probe in einem Probenröhrchen in eine Probensonde gegeben, welche im NMR-Spektrometer vermessen wird.

Zur Probenvorbereitung für NMR-Messungen wird typischerweise ein sog. XYZ-Liquid-Handler benutzt. Solche Liquid-Handler umfassen eine Pipettiervorrichtung, die in drei Raumrichtungen (X, Y, Z) verfahrbar ist. Viele zu untersuchende Proben werden in Probengefäßen bereitgestellt, die jeweils mit einem Septum verschlossen sind. Diese Septen müssen von einer Nadel mit Anschliff durchdrungen werden, um die Probe erreichen zu können. Der XYZ-Liquid-Handler weist dazu üblicherweise eine sog. Septum-Piercing-Nadel auf. Die Septum-Piercing-Nadel dient dabei typischerweise sowohl zum Durchstechen des Septums als auch zur Handhabung der Probenflüssigkeit.

Aus der Firmendruckschrift "SamplePro Tube - Customer Information" der Bruker BioSpin GmbH, Silberstreifen 4, D-76287 Rheinstetten vom 27.04.2015 ist ein Liquid-Handler bekannt geworden, bei dem Septum-Piercing-Nadeln frei hängend eingesetzt werden. Dieser Liquid-Handler umfasst weiterhin einen Niederhalter für Probengefäße.

Die DE 102 19 790 C1 beschreibt eine Probenhandhabungseinrichtung für ein Analysegerät.

In der DE 38 84 280 T2 ist ein Probenröhrchentransportsystem für ein Analysegerät beschrieben.

Aus der DE 25 37 606 A1 ist ein Verfahren zum automatischen Transportieren und Injizieren einer Flüssigkeitsprobe bekannt.

Die US 2009/0246085 A1 handelt von einem Flüssigkeitshandhabungssystem und von Verfahren zum Vermischen und Freisetzen von flüssigen Reagenzien.

Die US 6,666,100 B1 zeigt einen Probeninjektor mit Schalter zur Schnittstellenkontrolle.

Die US-A 5,517,867 schließlich offenbart eine Apparatur zur Extraktion von Flüssigkeit.

Ein einfaches Überprüfen der Probenposition mit Hilfe des Niederhalters durch gleichzeitiges Messen eines Motorstroms beim Anfahren einer gesetzten Z-Position (Vertikalposition) ist mit diesem Liquid-Handler zwar bei einigen, aber nicht bei allen üblicherweise eingesetzten Probengefäßen möglich. Speziell bei dicht stehenden Gefäßen mit kleiner Öffnung ist eine Prüfung der Probenposition nicht möglich.

Neben Probengefäßen, die mitunter eine relativ große oberseitige Öffnung aufweisen (3 bis 5 mm Durchmesser), müssen u.a. auch Objekte mit sehr kleinen Innendurchmessern (z.B. NMR-Röhrchen) befüllt werden. Es gibt NMR-Röhrchen, die mit präparierter Probenflüssigkeit gefüllt werden müssen, die 1,0 mm bzw. 1,7 mm Außendurchmesser und dementsprechend kleine Innendurchmesser von nur 0,7 mm oder 0,8 mm bzw. 1,4 mm haben. Solche NMR-Röhrchen können nur mit einer dünnen Nadel mit geringeren Außenabmaßen angefahren werden. Nadeln mit Außendurchmessern von weniger als 1 mm sind jedoch zu labil, als dass man damit Septen von bis zu 3 mm Stärke durchstoßen kann.

Septum-Piercing-Nadeln können eine Länge von bis zu 200 mm bei Außendurchmessern zwischen 0,5 mm und 1,5 mm erreichen. Sie sind daher relativ labil. Es ist dann eine Führung der Nadeln notwendig um ein Knicken oder Verbiegen der Nadeln zu verhindern.

In der eingangs zitierten Firmendruckschrift "Triathlon user manual" wird eine Pipettiervorrichtung für einen Liquid-Handler beschrieben, die eine Piercing-Nadel und eine Proben-Nadel aufweist. Die Piercing-Nadel dient zum Durchstechen eines Septums, das ein Probengefäß verschließt. Die Analyse-Nadel ist konzentrisch innerhalb der Piercing-Nadel angeordnet, und dient zum Handhaben von Probenflüssigkeiten.

Ein Liquid-Handler hat jedoch durch seinen Aufbau und die Mechanik zum Verfahren der Pipettiervorrichtung gewisse Ungenauigkeiten in der räumlichen Ausrichtung der Pipettiervorrichtung. Ferner weisen die verwendeten Probengefäße (Maß-)Toleranzen auf. Auch ist die Positionierung der Probengefäße in einer Haltevorrichtung gewissen (Positions-)Ungenauigkeiten unterworfen. Es können sich dadurch Abweichungen in der Relativposition zwischen der Pipettiervorrichtung und den Probengefäßen ergeben, welche sich durchaus in einem Bereich von +/- 1 mm bewegen können. Außerdem gibt es in NMR-Applikationen Probengefäße mit sehr engen Öffnungen, wie z.B. sog. NMR-SampleJet-Röhrchen mit ca. 2 mm Öffnungsdurchmesser. Es besteht daher die Gefahr, dass die in der Pipettiervorrichtung des Liquid-Handlers verwendeten Nadeln nicht mittig auf das Septum treffen oder gar auf einen oberen Rand des Probengefäßes stoßen. Ein solches Fehlpositionieren der Nadeln ist jedoch zu vermeiden, da es unweigerlich zur Zerstörung der Nadeln führen würde.

Weiterhin hält die Friktion des Septums eine ins Septum eingestochene Nadel fest. Beim Herausziehen der Nadel muss daher das Septum bzw. ein Probengefäß mit dem Septum aktiv abgestreift werden. Dies kann bewerkstelligt werden, indem man das Probengefäß fest auf einer Arbeitsplatte verankert, was aber für jede Position und Gefäßform einer individuellen und oft aufwendigen Mechanik bedarf.

### Aufgabe der Erfindung

Der Erfindung liegt die Aufgabe zugrunde, eine konstruktiv einfache Pipettiervorrichtung anzugeben, die es auch bei Verwendung von sehr dünnen Pipettiernadeln ermöglicht, das Septum eines Probengefäßes sicher zu durchstechen und die Pipettiernadel wieder leicht aus dem Septum herausziehen zu können.

### Kurze Beschreibung der Erfindung

Diese Aufgabe wird durch die vorliegende Erfindung auf ebenso überraschend einfache wie wirkungsvolle Weise dadurch gelöst, dass die Pipettiervorrichtung einen Führungsarm umfasst, an dessen unterem Ende eine Endplatte angeordnet ist, die entlang des Führungsarms gegen einen federnden Widerstand axial verschiebbar ist, dass die Pipettiervorrichtung eine Zentriervorrichtung vorgesehen ist, die in die Endplatte des Führungsarms aufweist, dass radial außen in Umfangsrichtung um die Zentriervorrichtung verteilt mindestens drei Zentrierfinger mit konischen Abschrägungen ausgebildet sind, die eine Niederhalteeinrichtung für das Probengefäß bilden und im Betrieb das Probengefäß oberseitig von außen umgreifen können, und dass die Zentriervorrichtung zwischen den Zentrierfingern kreissegmentförmige Einbuchtungen aufweist.

Durch die Zentriervorrichtung kann die Pipettiervorrichtung relativ zu dem Probengefäß präzise ausgerichtet werden. Es kann dadurch sichergestellt werden, dass das Septum stets in seiner Mitte durchstochen wird. Das Septum kann beispielsweise aus Silikon, Gummi, PTFE oder aus verschiedenen Kombinationen von Materialien, wie z.B. Silikon mit PTFE-Beschichtung, gefertigt sein.

Die Hilfskanüle dient zum Durchstechen des Septums. Sie kann dazu kurz und mit einem im Vergleich zu der Pipettiernadel großen Außendurchmesser und einer größeren Wandstärkte ausgeführt werden. Die Hilfskanüle dient weiterhin auch zur Führung und Abstützung der Pipettiernadel. Die Pipettiernadel kann axial durch die Hilfskanüle durchgeführt werden. Ein Innendurchmesser der Hilfskanüle entspricht daher mindestens einem Außendurchmesser der Pipettiernadel.

Ein Zentrieren der Pipettiervorrichtung auf dem Probengefäß ist insbesondere dann notwendig, wenn eine Öffnung des Probengefäßes, die von dem Septum verschlossen wird, einen kleinen Durchmesser aufweist. Dann haben nämlich bereits kleine Positionierfehler zur Folge, dass beim Versuch des Durchstechens des Septums ein oberer Rand des Probengefäßes getroffen wird. Das Zentrieren der Pipettiervorrichtung auch auf anderen Probengefäßen mit einer größeren Septum-Öffnung, wie z.B. 2 ml Auto-Sampler-Vials, ist ebenfalls von Vorteil. Ein Septum lässt sich im Zentrum wesentlich leichter durchdringen als außerhalb des Zentrums. Die Belastung der Hilfskanüle ist dadurch geringer.

Dadurch dass die Zentriervorrichtung zwischen den Zentrierfingern kreissegmentförmige Einbuchtungen aufweist, kann erreicht werden, dass zwischen benachbarten Probengefäßen nur ein geringer Abstand (z.B. nur 3 mm oder auch nur 2 mm) eingerichtet werden muss, um diese mit der Zentriervorrichtung umgreifen zu können. Die Zentrierfinger ragen dabei in Freiräume zwischen nebeneinander stehenden Probengefäßen hinein, während die Einbuchtungen zwischen den benachbarten Probengefäßen angeordnet werden. Dies minimiert einen zwischen den Probengefäßen notwendigen Abstand.

Das Probengefäß ist typischerweise mit weiteren Probengefäßen dicht gepackt auf einer Arbeitsplatte angeordnet. Es können z.B. 96 NMR-Röhrchen im Well-Plate-Format sehr dicht, d.h. mit nur geringem Abstand, nebeneinander stehen. Durch die Zentriervorrichtung mit Einbuchtungen können diese dennoch präzise mit der Pipettiervorrichtung angefahren werden. Mit dieser Zentriervorrichtung kann als weitere Funktion festgestellt werden, ob ein ausgewähltes Probengefäß in einer angefahrenen Position sitzt oder ob diese Position nicht belegt ist. Damit dies bewerkstelligt werden kann, muss die Zentriervorrichtung tiefer als in eine Zentrierposition (zumindest tiefer als in diejenige Vertikalposition der Zentriervorrichtung, in der die Zentriervorrichtung zentriert auf dem Probengefäß aufsitzt) fahren können. Auch damit man diese tiefere Position zwischen den anderen Gefäßpositionen erreichen kann, ist die Zentrierhilfe mit den kreissegmentförmigen Einbuchtungen ausgebildet. Die Zentriervorrichtung ist in die Endplatte des Führungsarms einsetzbar. Die Endplatte ist unterseitig an dem Führungsarms angeordnet. Die Endplatte ist entlang des Führungsarms gegen einen federnden Widerstand verschiebbar. Der Führungsarm kann dazu mit einer Linearführung für die Endplatte ausgebildet werden. Der federnde Widerstand wird vorzugsweise von einer Feder, insbesondere einer zylindrischen Schraubenfeder, gebildet. Alternativ können auch eine Blattfeder, eine Gasfeder, eine Gummifeder oder andere Mechanismen mit elastisch deformierbaren Elementen vorgesehen sein. Der federnde Widerstand wirkt einer Bewegung der Endplatte auf eine oberseitige Aufhängung des Führungsarms zu entgegen. Eine Ruheposition, in der federnde Widerstand die Endplatte zu drücken sucht, kann von einem Anschlag an dem Führungsarm definiert sein.

Die Zentriervorrichtung weist radial außen in Umfangsrichtung um die Zentriervorrichtung verteilt mindestens drei Zentrierfinger mit konischen Abschrägungen auf. Durch die Abschrägungen der Zentrierfinger wird ein Fangbereich der Zentriervorrichtung vergrößert, d.h. es werden auch Probengefäße, die zunächst deutlich neben einer Mittelachse der Zentriervorrichtung angeordnet sind, von den Zentrierfingern erfasst und beim Absenken der Zentriervorrichtung ins Zentrum der Zentriervorrichtung gedrückt. Damit kann erreicht werden, dass Objekte (d.h. insbesondere Probengefäße) mit Außendurchmessern von beispielsweise 6 bis 14 mm zuverlässig eingefangen und zentriert werden können. Je nach ihrem Außendurchmesser können die zentrierten Probengefäße mit einem oberseitigen Rand an den Abschrägungen der Zentriervorrichtung anliegen oder innerhalb einer im Wesentlichen zylindrischen bzw. zylindersegmentförmigen Zentrierausnehmung aufgenommen werden.

Die Zentriervorrichtung wird im Betrieb der Pipettiervorrichtung beim Absenken der oberseitigen Aufhängung des Führungsarms von dem federnden Widerstand gegen das Probengefäß gedrückt. Dadurch kann bewirkt werden, dass das Probengefäß in das Zentrum der Zentriervorrichtung rutscht und dass das Probengefäß dort sicher festgehalten wird. Das Probengefäß wird dann oberseitig von außen von den Zentrierfingern umgriffen.

Die Hilfskanüle ist typischerweise oberhalb der verschiebbaren Endplatte an dem Führungsarm befestigt. Die Hilfskanüle kann dazu in eine Auskragung des Führungsarms eingeschraubt werden. Eine Längsachse der Hilfskanüle ist üblicherweise parallel zu einer Längserstreckungsrichtung des Führungsarms ausgerichtet.

Vorzugsweise ist die Hilfskanüle nicht gegenüber der oberseitigen Aufhängung des Führungsarms verschiebbar, insbesondere nicht in axialer Richtung, d.h. entlang des Führungsarms. Ein unteres, freies Ende der Hilfskanüle ist zum Durchstechen des Septums ausgebildet. Wenn die Endplatte mit der Zentriervorrichtung sich in einer unteren Stellung befindet, ist das freie Ende der Hilfskanüle vorzugsweise innerhalb der Zentriervorrichtung angeordnet. Wenn die Zentriervorrichtung gegen den federnden Widerstand nach oben geschoben wird, tritt dann das freie Ende der Hilfskanüle aus der Zentriervorrichtung hervor. Das freie Ende der Hilfskanüle kann dann das Septum des Probengefäßes durchstechen. Die Zentrierfunktion bleibt während des gesamten Vorgangs erhalten, da die Pipettiernadel relativ zu der Zentriervorrichtung verschoben wird, während die Zentriervorrichtung stets von dem federnden Widerstand auf das Probengefäß gedrückt wird

Das Andrücken der Zentriervorrichtung gegen das Probengefäß durch den federnden Widerstand bewirkt auch, dass das Probengefäß beim Herausziehen der Hilfskanüle aus dem Septum nicht angehoben wird. Die Zentrierfinger, die das Probengefäß oberseitig umgriffen halten, bilden insofern eine Niederhaltevorrichtung für das Probengefäß aus. Septen haben durch ihre Dichtungseigenschaft per se eine hohe Friktion, so dass die Hilfskanüle mit Kraft aus diesen herausgezogen werden muss. Vorzugsweise ist daher der federnde Widerstand so eingerichtet und auf die Längsposition des freien Endes der Hilfskanüle relativ zum Führungsarm abgestimmt, dass noch eine ausreichende Anpressung der Zentriervorrichtung gegen das Probengefäß erfolgt, wenn die Hilfskanüle bereits weitestgehend aus dem Septum herausgezogen worden ist. Die Zentriervorrichtung an der federnd abgestützten Endplatte bildet somit einen generellen (universell einsetzbaren) Abstreifer aus, der bei verschiedenen Typen von Probengefäßen einsetzbar ist. Gesonderte, aufwendige Einrichtungen, um die Probengefäße an einer Arbeitsplatte zu verankern, so dass diese nicht in vertikaler Richtung angehoben werden können, sind daher bei Verwendung der erfindungsgemäßen Pipettiervorrichtung nicht erforderlich.

Mit der vorliegenden Erfindung werden insbesondere auch folgende Vorteile erzielt:
- Es können Pipettiernadeln mit unterschiedlichen Dimensionen eingesetzt werden, etwa mit einer Länge zwischen 100 mm und 250 mm, einem Außendurchmesser zwischen 0,5 mm und 2,5 mm und/oder einem Innendurchmesser zwischen 0,25 mm und 1,6 mm. Ein Einsatz von Pipettiernadeln mit diversen Außendurchmessern (0,5mm bis 2,5mm) auf dem gleichen System kann je nach Applikation erforderlich sein. Die Hilfskanüle wirkt als eine Nadelführung. Hilfskanülen können mit unterschiedlichen Innendurchmessern versehen werden, die jeweils nur geringfügig größer sind, als der Außendurchmesser der eingesetzten Pipettiernadel, so dass die Pipettiernadel in der Hilfskanüle präzise und sicher geführt wird.
- Es wird der Einsatz von Pipettiernadeln mit geringem Außendurchmesser ermöglicht. Die Pipettiernadeln müssen insbesondere nicht so stabil ausgeführt werden, dass sie das Septum durchstoßen können. Die Hilfskanüle kann kurz und relativ stark (großer Durchmesser, große Wandstärke) ausgeführt werden, um auch dicke Septen durchstechen zu können. Die Hilfskanüle schafft eine Öffnung, durch die die Pipettiernadel ohne Kraftaufwand und ohne Belastung der Pipettiernadel in das Probengefäß eingeführt und aus dem Probengefäß herausgezogen werden kann.
- Die Zentriervorrichtung gewährleistet ein zentrisches Penetrieren des Septums, insbesondere auch bei kritischen Probengefäßen mit einer kleinen Öffnung. Die Zentriervorrichtung ist durch die konischen Abschrägungen der Zentrierfinger in einem Kontaktbereich zum Probengefäß insgesamt konisch geformt, so dass ein Fangbereich entsteht, der je nach Probengefäß radiale Positionsabweichungen zwischen Probengefäß und Zentriervorrichtung von bis zu +/-3 mm erfasst. D.h. auch ein relativ zu der Zentriervorrichtung zunächst außermittig angeordnetes Probengefäß wird von der Zentriervorrichtung erfasst und beim Andrücken der Zentriervorrichtung konzentrisch zu der Zentriervorrichtung ausgerichtet. Es kann dann das Septum genau mittig durchstochen werden.
- Ein Niederhalten des Probengefäßes beim Herausziehen der Hilfskanüle ist durch die federnde Abstützung der Zentriervorrichtung an dem Führungsarm gewährleistet.

### Bevorzugte Ausführungsformen und Weiterbildungen der Erfindung

Besonders bevorzugt ist eine Ausführungsform der erfindungsgemäßen Überwachungszelle, bei der die Zentriervorrichtung in die Endplatte einschraubbar ist. Dadurch kann die Zentriervorrichtung einfach und sicher in der Endplatte befestigt werden. Insbesondere kann die Zentriervorrichtung auch schnell ausgetauscht werden. Ein Wechsel der Zentriervorrichtung kann durch Verschleiß, oder Anpassen an Applikationsbedingungen von Nöten sein.

Eine dazu alternative Ausführungsform sieht vor, dass die Zentriervorrichtung in die Endplatte einrastbar, einklemmbar oder mittels eines Bajonettverschlusses einsetzbar ist. Dies erlaubt einen sehr einfachen Wechsel der Zentriervorrichtung. Insbesondere können solche Befestigungsmechanismen auch von Laborpersonal sicher und zuverlässig bedient werden.

Besonders bevorzugt ist eine Ausführungsform, bei der eine Verdrehsicherung vorgesehen ist, die so ausgebildet, dass sie eine definierte Ausrichtung der Zentriervorrichtung relativ zur Endplatte ermöglicht, wobei die Verdrehsicherung insbesondere wenigstens zwei, bevorzugt vier, oberseitige Vorsprünge der Zentriervorrichtung aufweist, die die Endplatte seitlich umgreifen. Durch die Verdrehsicherung wird gewährleistet, dass sich die Ausrichtung der Zentriervorrichtung während der Benutzung nicht mehr verändern kann. Die exakte Ausrichtung der Zentrierfinger ist wichtig, um Konflikte mit benachbarten Probengefäßen zu vermeiden. Insbesondere können nur bei exakter Orientierung der Zentriervorrichtung bei eng stehenden Probengefäßen Freiräume zwischen den Probengefäßen genutzt werden, um die Zentrierfinger an den Probengefäßen vorbeizuführen. Typischerweise sind die Probengefäße in einem quadratischen Muster dichtgepackt nebeneinander angeordnet. Selbst ein leichtes Verdrehen der Zentriervorrichtung würde die Funktion zunichtemachen, da die Zentrierfinger mit benachbarten Probengefäßen kollidieren würden. Die oberseitig angebrachten Vorsprünge und eine Breite der Endplatte sind so abgestimmt, dass sich die Zentrierhilfe beim Einsetzen automatisch selbst justiert und in der korrekten Ausrichtung gegen Verdrehen gesichert wird.

Vorteilhaft ist auch eine Ausführungsform, bei der vorgesehen ist, dass die Zentriervorrichtung unterseitig eine koaxial zur Hilfskanüle angeordnete, vorzugsweise ringförmige Abhebehilfseinrichtung aufweist. Durch die Abhebehilfseinrichtung kann vermieden werden, dass eine mögliche Tröpfchenbildung an der Hilfskanüle dazu führt, dass Probengefäße an der Zentriervorrichtung aufgrund von Adhäsion haften bleiben und aus ihrer ursprünglichen Position entfernt werden. Es lässt sich nämlich nicht ganz vermeiden, dass Flüssigkeitströpfchen nach dem Pipettieren oder nach einem Reinigungs- und Waschvorgang sowohl an der Pipettiernadel, der Hilfskanüle als auch an der Zentriervorrichtung haften bleiben. Ohne die Abhebehilfseinrichtung unterseitig an der Zentriervorrichtung besteht die Gefahr, dass durch Adhäsionskräfte der Flüssigkeit zwischen dem Septum bzw. dem Probengefäß und der Zentrierhilfe das Probengefäß "kleben" bleibt und aus seiner Position entfernt wird, bzw. bei einer weiteren räumlichen Bewegung der Pipettiervorrichtung zerstört wird. Durch die Abhebehilfseinrichtung wird die Kontaktfläche der Zentriervorrichtung so weit verringert, dass dieser Effekt verhindert wird.

Die Abhebehilfseinrichtung kann insbesondere auch durch Ringsegmente gebildet werden. Durch die Abhebehilfseinrichtung wird sichergestellt, dass sich die Zentriervorrichtung nach dem Herausziehen der Hilfskanüle aus dem Septum von dem Probengefäß löst und von diesem abgehoben werden kann. Dazu wird durch die Abhebehilfseinrichtung eine Kontaktfläche zwischen dem Septum und der Zentriervorrichtung verringert. Die Abhebehilfseinrichtung verhindert einen großflächigen Kontakt der Zentriervorrichtung mit dem Septum. Stattdessen werden ein kleiner oder mehrere kleine Kontaktbereiche eingerichtet. Insbesondere kann ein sehr schmaler (z.B. mit einer Breite kleiner 1,0 mm oder kleiner 0,6 mm), ringförmiger Kontaktbereich eingerichtet werden. Dadurch können Adhäsionskräfte oder dergleichen zwischen der Zentriervorrichtung und dem Probengefäß bzw. dem Septum so weit reduziert werden, dass die Gewichtskraft des Probengefäßes ausreicht, um diese Kräfte zu überwinden.

Eine bevorzugte Ausführungsform ist dadurch gekennzeichnet, dass zwischen der Hilfskanüle und der Pipettiernadel ein Belüftungskanal für das Probengefäß eingerichtet ist, wenn die Pipettiernadel axial durch die Hilfskanüle durchgeführt ist. Dadurch wird eine präzise Entnahme eines vorgegebenen Volumens von Probenflüssigkeit aus dem Probengefäß oder ein präzises Einfüllen eines vorgegebenen Volumens von Probenflüssigkeit in das Probengefäß ermöglicht.

Ein Fördern (Ansaugen bzw. Abgeben) von exakten Volumina ist bei üblicherweise zum Pipettieren eingesetzten Pumpen druckabhängig. Ein Druckausgleich zwischen einer Umgebung und einem Innenraum des Probengefäßes ist also notwendig, um eine angestrebte Flüssigkeitsmenge (anzusaugendes bzw. abzugebendes Volumen der Probenflüssigkeit) exakt einhalten zu können. Nach dem Durchstoßen des Septums muss daher das Probengefäß belüftet werden, um einen Unterdruck beim Absaugen von Probenflüssigkeit aus dem Probengefäß bzw. einen Überdruck beim Abgeben von Probenflüssigkeit in das Probengefäß zu vermeiden. Um den Belüftungskanal einzurichten, wird vorzugsweise ein Abstand zwischen einer Außenwand der Pipettiernadel und einer Innenwand der Hilfskanüle eingerichtet. Insbesondere kann ein Außendurchmesser der Pipettiernadel kleiner gewählt werden als ein Innendurchmesser der Hilfskanüle.

Die Pipettiernadel kann dann konzentrisch oder außermittig in der Hilfskanüle angeordnet werden. Alternativ oder zusätzlich können auch die Pipettiernadel außenseitig und/oder die Hilfskanüle innenseitig mit einer in Längsrichtung durchgehenden Einkerbung, etwa in der Art einer Gravur, versehen werden. Es wird jedenfalls ein Belüftungskanal für das Probengefäß eröffnet, der einen Druckausgleich zwischen einer Umgebung und einem Innenraum des Probengefäßes ermöglicht. Damit kann erreicht werden, dass in dem Probengefäß beim Pipettieren immer dieselben Druckverhältnisse herrschen.

Eine vorteilhafte Ausführungsform sieht vor, dass die Zentrierfinger der Zentriervorrichtung unterseitig in Umfangsrichtung der Zentriervorrichtung abgeschrägt sind. Dadurch können Konflikte mit benachbarten Probengefäßen minimiert werden, d.h. es kann vermieden werden, dass die Zentrierfinger mit unmittelbar benachbarten Probengefäßen kollidieren.

Bei einer besonders bevorzugten Ausführungsform ist vorgesehen, dass die Zentrierfinger gleichmäßig über den Umfang der Zentriervorrichtung verteilt angeordnet sind. Die Probengefäße sind in typischerweise gleichmäßig in Haltern angeordnet. Es entstehen dadurch gleichmäßig verteilte Freiräume, in die Zentriervorrichtung mit gleichmäßig verteilten Fingern eingreifen kann. Weiterhin wird dadurch sichergestellt, dass die Zentriervorrichtung auf dem Probengefäß in alle horizontalen Richtungen gleichermaßen abgestützt wird.

Ganz besonders bevorzugt ist eine Ausführungsform, bei der die Zentriervorrichtung vier jeweils paarweise gegenüberliegend angeordnete Zentrierfinger aufweist. Die Probengefäße sind in aller Regel in Reihen und Zeilen gleichmäßig in Haltern angeordnet. Es entstehen dadurch an jedem Probengefäß vier jeweils paarweise gegenüberliegende Freiräume. In diese Freiräume kann die Zentriervorrichtung eingreifen, wenn die Zentrierfinger jeweils paarweise gegenüberliegend angeordnet sind.

Vorteilhaft ist auch eine Ausführungsform, bei der die Zentriervorrichtung auch ohne Werkzeug in die Endplatte des Führungsarms einsetzbar und aus der Endplatte ausbaubar ist. Dadurch wird ein besonders schneller und einfach durchführbarer Wechsel der Zentriervorrichtung ermöglicht. Insbesondere kann dadurch auch technisch ungebildetes Labor- oder Hilfspersonal in die Lage versetzt werden, einen Wechsel der Zentriervorrichtung sicher und fehlerlos durchzuführen. Ein Wechsel der Zentriervorrichtung kann notwendig sein, wenn Probengefäße mit anderen Außendurchmessern und/oder andere Pipettiernadeln und/oder andere Hilfskanülen eingesetzt werden sollen.

In den Rahmen der vorliegenden Erfindung fällt auch ein Verfahren zum Detektieren des Vorhandenseins und gegebenenfalls der Position eines Probengefäßes mittels einer oben beschriebenen, erfindungsgemäßen Pipettiervorrichtung, umfassend folgende Schritte:
a) Festlegen einer vertikalen Zielposition für die Zentriervorrichtung,
b) Absenken der Zentriervorrichtung am Führungsarm unter Überwachung einer aktuellen Vertikalposition der Zentriervorrichtung, bis ein Widerstand dem weiteren Absenken entgegen wirkt oder bis die Zentriervorrichtung eine vordefinierte Tiefstposition erreicht hat,
c) Auswerten der in Schritt b) erreichten Vertikalposition der Zentriervorrichtung, wobei
   i. eine Vertikalposition unterhalb der Zielposition bedeutet, dass kein Probengefäß gefunden wurde,
   ii. eine Vertikalposition, die der Zielposition entspricht, bedeutet, dass die Zentriervorrichtung auf einem Probengefäß zentriert ist,
   iii. eine Vertikalposition oberhalb der Zielposition bedeutet, dass die Zentriervorrichtung auf einem Probengefäß aufreitet, ohne zentriert zu sein.

Dieses Verfahren ermöglicht es, automatisiert zu erkennen, ob das Probengefäß vorhanden ist und ob die Zentriervorrichtung auf dem Probengefäß zentriert ist. Das automatisierte Erkennen, ob das Probengefäß vorhanden ist und ob die Zentrierung korrekt ist, erhöht die Sicherheit in der Automation wesentlich. Es wird dazu aktiv überprüft, ob an der vorgesehenen Position ein Probengefäß steht und eine Präparation mit Probenflüssigkeit aus dem Probengefäß durchgeführt werden kann.

Im Stand der Technik wird dazu ein Barcodeleser verwendet oder es werden Bilder angefertigt und einer relativ aufwendigen Softwareauswertung unterzogen. Bei eng stehenden, kleinen Probengefäßen ist dies jedoch nur mit größerem Aufwand möglich. Es ist dann z.B. ein zusätzliches Greifermodul notwendig, welches das Probengefäß zu einer Barcode-Leseposition transportiert oder welches mit einem zusätzlichen Sensor die Position abtastet, an der das Probengefäß erwartet wird. Dieser zusätzliche Aufwand kann erfindungsgemäß vermieden werden.

Ein Auftreffen der Zentriervorrichtung auf das Probengefäß kann beispielsweise festgestellt werden, indem ein Strom durch einen Antriebsmotor zum vertikalen Verfahren der Pipettiervorrichtung überwacht wird. Beim Auftreffen auf ein Probengefäß steigt dieser Strom typischerweise an. Der Anstieg des Stroms kann von einer Software erkannt werden. Die aktuelle Vertikalposition der Zentriervorrichtung kann direkt über eine Wegmesseinrichtung oder indirekt aus Betriebszuständen (z.B. zeitlicher Verlauf der Stromaufnahme) des Antriebsmotors ermittelt werden.

Im Fall "i." wurde kein Probengefäß gefunden. Ein Präparationsauftrag wird dann storniert. Es wird dann mit dem nächsten Präparationsauftrag weitergemacht. Bei Situation "ii." ist alles ok und eine Präparation mit dem Probengefäß wird normal abgearbeitet. Bei Situation "iii." hat keine Zentrierung stattgefunden. Das ist ein kritischer Zustand, der zur Zerstörung der Hilfskanüle und/oder Pipettiernadel bzw. zum Probenverlust führen kann. In diesem Fall wird die Präparation abgebrochen.

Ferner betrifft die Erfindung ein Verfahren zum Entnehmen von Probenflüssigkeit aus einem Probengefäß mit einer erfindungsgemäßen Pipettiervorrichtung, wobei zunächst das vorstehend beschriebene, erfindungsgemäße Verfahren zum Detektieren eines Probengefäßes durchgeführt wird, und wobei in den Fällen i. und iii. das Entnahmeverfahren abgebrochen wird und nur im Fall ii. weiterhin die folgenden Schritte durchgeführt werden:
d) weiteres Absenken einer oberseitigen Aufhängung des Führungsarms gegen den federnden Widerstand, so dass die Hilfskanüle das Septum des Probengefäßes penetriert,
e) axiales Durchführen der Pipettiernadel durch die Hilfskanüle in das Probengefäß hinein,
f) Absaugen von Probenflüssigkeit aus dem Probengefäß in die Pipettiernadel,
g) Herausziehen der Pipettiernadel aus dem Probengefäß,
h) Anheben der oberseitigen Aufhängung des Führungsarms bis die Hilfskanüle aus dem Septum herausgezogen ist, wobei die Niederhalteeinrichtung gegen die Oberseite des Probengefäßes drückt,
i) weiteres Anheben der oberseitigen Aufhängung des Führungsarms, so dass sich die Zentriervorrichtung von dem Probengefäß löst.

Das erfindungsgemäße Verfahren kann analog auch zum Einbringen von Probenflüssigkeit in ein Probengefäß eingesetzt werden.

Dieses Verfahren ermöglicht es, zuverlässig und sicher mit der Pipettiervorrichtung eine Probenpräparation in dem Probengefäß durchzuführen. Insbesondere kann dabei auf eine gesonderte Verankerung des Probengefäßes an einer Arbeitsplatte verzichtet werden. Durch die Zentriervorrichtung wird weiterhin sichergestellt, dass das Septum des Probengefäßes mittig durchstochen wird. Beschädigungen der Pipettiernadel können somit sicher vermieden werden.

Nachdem die Hilfskanüle in das Probengefäß eingedrungen ist, wird die dünnere Pipettiernadel nachgeschoben und Probenflüssigkeit entnommen bzw. dazu geben. Durch einen Belüftungskanal zwischen der Hilfskanüle und der Pipettiernadel kann gleichzeitig ein Druckausgleich stattfinden. Nach dem Herausziehen der Pipettiernadel fährt auch der Führungsarm inklusive der Hilfskanüle nach oben, wobei zunächst die federnd abgestützte Endplatte mit der Zentriervorrichtung auf Grund des Federdrucks auf dem Probengefäß verbleibt. Nachdem die Hilfskanüle komplett aus dem Septum heraus gezogen wurde, wird der Führungsarm weiter angehoben, wobei die Endplatte mit der Zentriervorrichtung von dem federnden Widerstand in eine Ruheposition gedrückt wird, die von einem Anschlag an dem Führungsarm definiert werden kann. In der Ruheposition kann noch eine Vorspannung des federnden Widerstandes verbleiben.

Durch die Vorspannung kann sichergestellt werden, dass während des gesamten Herausziehens der Hilfskanüle aus dem Septum eine Anpressung der Zentriervorrichtung an das Probengefäß erfolgt, wobei eine Anpresskraft die zum Herausziehen der Hilfskanüle notwendige Kraft zu jedem Zeitpunkt übersteigt. Die Ruheposition der Endplatte an dem Führungsarm wird vorzugsweise erst erreicht nachdem, die Hilfskanüle vollständig aus dem Septum herausgezogen worden ist. Nachdem die Endplatte mit der Zentriervorrichtung in die Ruheposition zurückgekehrt ist, löst sich auch die Zentriervorrichtung wieder von dem Probengefäß.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine schematische Darstellung einer erfindungsgemäßen Pipettiervorrichtung mit einer Endplatte in einer Ruheposition;
- Fig. 1b: die Pipettiervorrichtung von Fig. 1a mit der Endplatte in einer Pipettierposition;
- Fig. 2a: eine schematische Darstellung einer Zentriervorrichtung für eine erfindungsgemäße Pipettiervorrichtung in Ansicht von schräg unten;
- Fig. 2b: eine Ansicht von schräg oben auf die Zentriervorrichtung von Fig. 2a;
- Fig. 3a: eine schematische Darstellung von Probengefäßen und einer Zentriervorrichtung für eine erfindungsgemäße Pipettiervorrichtung im Fall i. während eines erfindungsgemäßen Verfahrens;
- Fig. 3b: die Anordnung von Fig. 3a bei Ansicht entlang Schnittlinie A-A;
- Fig. 3c: eine schematische Darstellung von Probengefäßen und einer Zentriervorrichtung für eine erfindungsgemäße Pipettiervorrichtung im Fall ii. während eines erfindungsgemäßen Verfahrens;
- Fig. 3d: die Anordnung von Fig. 3c bei Ansicht entlang Schnittlinie A-A;
- Fig. 3e: eine schematische Darstellung von Probengefäßen und einer Zentriervorrichtung für eine erfindungsgemäße Pipettiervorrichtung im Fall iii. während eines erfindungsgemäßen Verfahrens;
- Fig. 3f: die Anordnung von Fig. 3e bei Ansicht entlang Schnittlinie A-A;
- Fig. 4a: eine schematische Ansicht einer erfindungsgemäßen Pipettiervorrichtung oberhalb eines Probengefäßes vor einem Pipettiervorgang;
- Fig. 4b: die Anordnung von Fig. 4a mit auf das Probengefäß aufgesetzter Zentriervorrichtung;
- Fig. 4c: die Anordnung von Fig. 4a mit in das Septum des Probengefäßes eingestochener Hilfskanüle;
- Fig. 4d: die Anordnung von Fig. 4a mit in das Probengefäß eingeführter Pipettiernadel;
- Fig. 4e: die Anordnung von Fig. 4a mit aus dem Probengefäß herausgezogener Pipettiernadel;
- Fig. 4f: die Anordnung von Fig. 4a mit von dem Probengefäß abgehobener Pipettiervorrichtung nach Abschluss des Pipettiervorgangs;
- Fig. 5a: eine erste Ausführungsform eines sehr dünnen Probengefäßes für eine erfindungsgemäße Pipettiervorrichtung;
- Fig. 5b: eine zweite Ausführungsform eines sehr dünnen Probengefäßes für eine erfindungsgemäße Pipettiervorrichtung;
- Fig. 6a: eine dritte Ausführungsform eines Probengefäßes zur Verwendung mit einer erfindungsgemäßen Pipettiervorrichtung;
- Fig. 6b: eine vierte Ausführungsform eines Probengefäßes zur Verwendung mit einer erfindungsgemäßen Pipettiervorrichtung;
- Fig. 7: eine Pipettiervorrichtung mit einer frei hängenden Septum-Piercing-Nadel aus dem Stand der Technik.

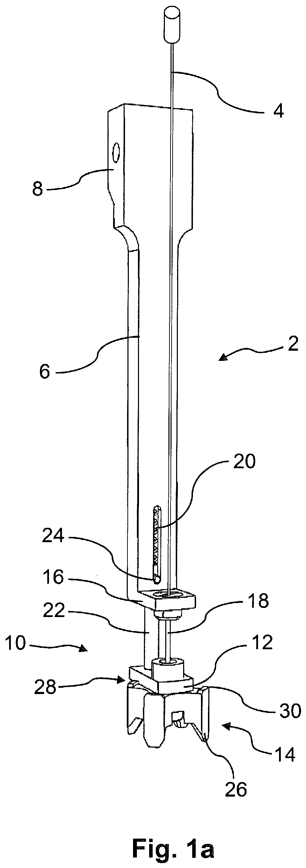

Die **Figur 1a** der Zeichnung zeigt in einer schematischen Ansicht eine bevorzugte Ausführungsform einer erfindungsgemäßen Pipettiervorrichtung 2. Die Pipettiervorrichtung 2 umfasst eine Pipettiernadel 4 und einen Führungsarm 6. Der Führungsarm 6 weist eine oberseitige Aufhängung 8 auf. An einem unteren Ende 10 des Führungsarms 6 ist eine Endplatte 12 angeordnet. In die Endplatte 12 ist eine Zentriervorrichtung 14 eingeschraubt. Oberhalb der Endplatte 12 ist eine Auskragung 16 an dem Führungsarm 6 ausgebildet. In die Auskragung 16 ist eine Hilfskanüle 18 eingeschraubt.

Die Endplatte 12 mit der Zentriervorrichtung 14 ist entlang des Führungsarms 6 gegen einen federnden Widerstand, der hier von einer Feder 20 gebildet wird, verschiebbar. Um die Verschiebbarkeit einzurichten, weist der Führungsarm 6 eine Linearführung 22 mit einem Anschlag 24 auf. In der Fig. 1a befindet sich die Endplatte 12 in einer Ruheposition, in die sie von der Feder 20 gedrückt wird. Der Anschlag 24 definiert hier die Ruheposition relativ zu dem oberen Ende 8 des Führungsarms 6. Ein freies Ende der Hilfskanüle 18 wird in der dargestellten Ruheposition von der Zentriervorrichtung 14 umschlossen.

Die Zentriervorrichtung 14 weist hier unterseitig vier einander paarweise gegenüberliegende Zentrierfinger 26 auf. Die Zentrierfinger 26 sind hier weiterhin gleichmäßig über den Umfang der Zentriervorrichtung 14 verteilt angeordnet, d.h. alle Zentrierfinger 26 sind gleich weit voneinander beabstandet. An der Zentriervorrichtung 14 ist hier oberseitig eine Verdrehsicherung 28 ausgebildet. Die Verdrehsicherung 28 umfasst hier vier Vorsprünge 30. Zwei der Vorsprünge 30 umgreifen die Endplatte 12 seitlich. Dadurch kann sichergestellt werden, dass sich die Zentriervorrichtung 14 im Betrieb der Pipettiervorrichtung 2 nicht gegenüber der Endplatte 12 verdreht. Die Vorsprünge 30 sind hier so auf die Endplatte 12 abgestimmt, dass die Zentriervorrichtung 14 ohne Werkzeug, d.h. mit der bloßen Hand, in die Endplatte 12 einschraubbar und aus der Endplatte 12 herausschraubbar ist.

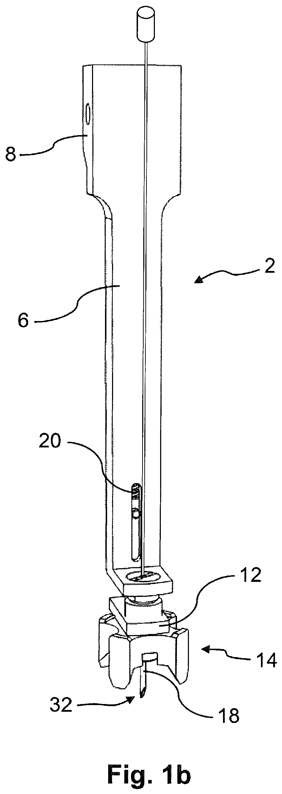

Die **Figur 1b** zeigt die Pipettiervorrichtung 2 von Fig. 1a, wobei hier die Endplatte 12 mit der Zentriervorrichtung 14 auf die obere Aufhängung 8 zu entlang des Führungsarms 6 nach oben verschoben ist. Die Feder 20 ist dadurch komprimiert worden. Das freie Ende 32 der Hilfskanüle 18 ragt nun unterseitig aus der Zentriervorrichtung 14 heraus.

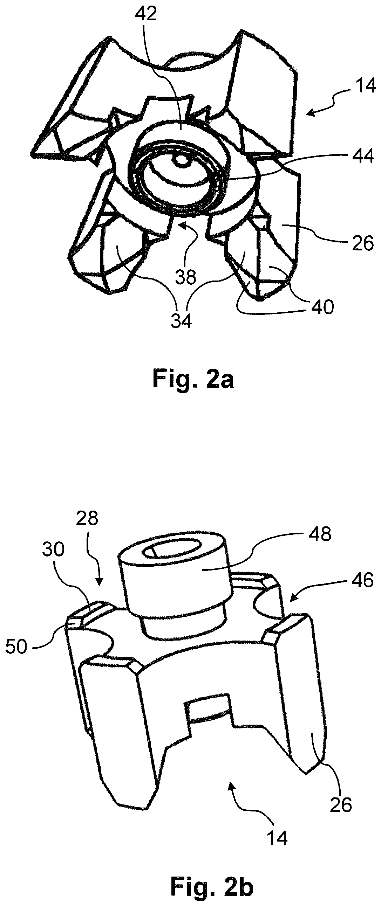

Die **Figur 2a** zeigt eine schematische Ansicht von schräg unten auf eine Zentriervorrichtung 14 für eine erfindungsgemäße Pipettiervorrichtung (nicht dargestellt). Die Zentriervorrichtung 14 weist hier vier gleichmäßig verteilte, einander paarweise gegenüberliegende Zentrierfinger 26 auf. Jeder Zentrierfinger 26 weist nach radial innen weisend eine konische Abschrägung 34 auf. Die konischen Abschrägungen 34 bilden zusammen eine Niederhalteeinrichtung für ein Probengefäß (nicht dargestellt) aus. Nach oben hin schließt sich an die konischen Abschrägungen 34 der Zentrierfinger 26 hier eine zylindersegmentförmige Zentrierausnehmung 38 an. Die Zentrierfinger 26 sind hier weiterhin unterseitig in Umfangsrichtung der Zentriervorrichtung 14 durch Schrägflächen 40 abgeschrägt. Durch die konischen Abschrägungen 34 und die Schrägflächen 40 sind die Zentrierfinger 26 damit unterenends insgesamt fassettenartig ausgebildet und laufen spitz zu.

Die Zentriervorrichtung 14 weist hier unterseitig zwischen den Zentrierfingern 26 innerhalb der Zentrierausnehmung 38 eine Abhebehilfseinrichtung 42 auf. Die Abhebehilfseinrichtung 42 ist hier zylinderringförmig ausgebildet. Die Abhebehilfseinrichtung 42 definiert auch eine obere Anschlagfläche 44 für ein Probengefäß innerhalb der Zentrierausnehmung 38.

Die **Figur 2b** zeigt die Zentriervorrichtung 14 von Fig. 2a von schräg oben. Die Zentriervorrichtung 14 ist hier mit kreissegmentförmigen Einbuchtungen 46 zwischen benachbarten Zentrierfingern 26 ausgebildet. Oberseitig ist an der Zentriervorrichtung 14 ein Gewindeabschnitt 48 zum Eingreifen in ein korrespondierendes Gewinde einer Endplatte (nicht dargestellt) ausgebildet. Jeweils oberhalb der Zentrierfinger 26 weist die Zentriervorrichtung 14 hier einen Vorsprung 30 auf. Die Vorsprünge 30 bilden zusammen eine Verdrehsicherung 28 für die Zentriervorrichtung 14. In Umfangsrichtung der Zentriervorrichtung 14 weisen die Vorsprünge 30 jeweils zwei Fasen 50 auf. Die Fasen 50 erleichtern ein Verrasten (Einschnappen) der Verdrehsicherung 28 an einer Endplatte.

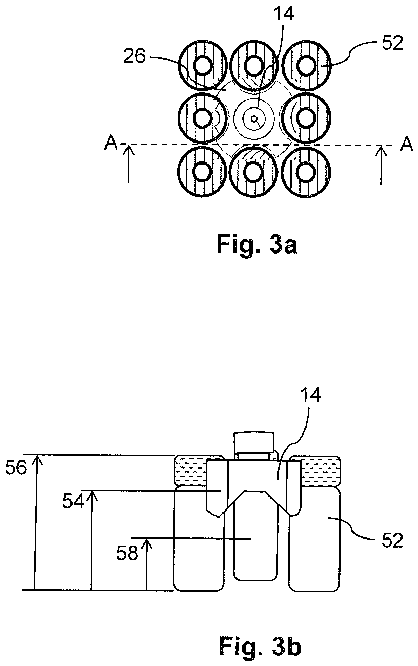

Die **Figur 3a** zeigt eine schematische Aufsicht auf eine Zentriervorrichtung 14 einer erfindungsgemäßen Pipettiervorrichtung (nicht dargestellt) und acht Probengefäße 52 während eines erfindungsgemäßen Verfahrens. Die **Figur 3b** zeigt die Anordnung von Fig. 3a in einer Seitenansicht bei Schnittebene A-A. Die Zentriervorrichtung 14 wurde hier in der Mitte zwischen den Probengefäßen 52 abgesenkt. Vier Zentrierfinger 26 der Zentriervorrichtung 14 greifen in Freiräume zwischen den Probengefäßen 52 ein. Da der mittlere Platz für ein Probengefäß leer ist, konnte die Zentriervorrichtung 14 so weit abgesenkt werden, dass eine aktuelle Vertikalposition 54 der Zentriervorrichtung 14 unterhalb einer vertikalen Zielposition 56 für die Zentriervorrichtung 14 liegt (Fall i.). Die vertikale Zielposition 56 entspricht hier einer Höhe der Probengefäße 52. Die Zentriervorrichtung 14 kann hier noch weiter bis zu einer vordefinierten Tiefstposition 58 abgesenkt werden.

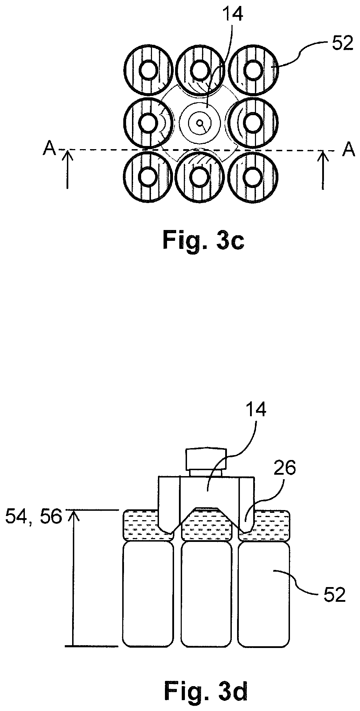

Die **Figur 3c** zeigt eine schematische Aufsicht auf eine Zentriervorrichtung 14 einer erfindungsgemäßen Pipettiervorrichtung (nicht dargestellt) und neun Probengefäße 52 während eines erfindungsgemäßen Verfahrens. Die **Figur 3d** zeigt die Anordnung von Fig. 3c in einer Seitenansicht bei Schnittebene A-A. Hier befindet sich auch ein Probengefäß 52 auf dem mittleren Platz unterhalb der Zentriervorrichtung 14 (in der Fig. 3c ist dieses Probengefäß 52 von der Zentriervorrichtung 14 verdeckt). Die Zentriervorrichtung 14 konnte deshalb gerade so weit abgesenkt werden, dass die aktuelle Vertikalposition 54 der Zentriervorrichtung 14 der vertikalen Zielposition 56 entspricht (Fall ii.). Das Probengefäß 52 unterhalb der Zentriervorrichtung 14 wird von Zentrierfingern 26 der Zentriervorrichtung 14 umgriffen.

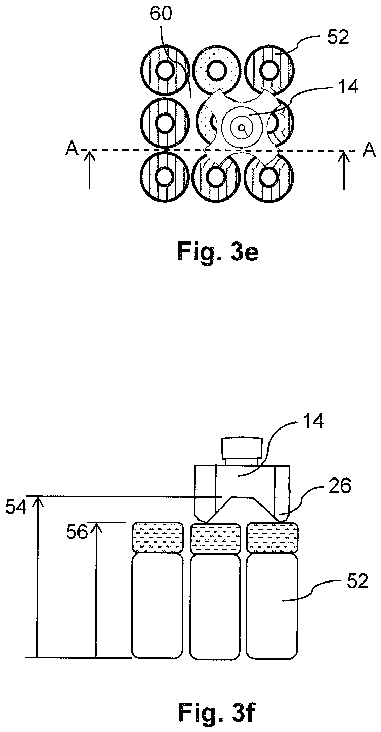

Die **Figur 3e** zeigt eine schematische Aufsicht auf eine Zentriervorrichtung 14 einer erfindungsgemäßen Pipettiervorrichtung (nicht dargestellt) und neun Probengefäße 52 während eines erfindungsgemäßen Verfahrens. Die **Figur 3f** zeigt die Anordnung von Fig. 3e in einer Seitenansicht bei Schnittebene A-A. Die Zentriervorrichtung 14 ist hier so weit gegenüber dem mittleren Probengefäß 52 versetzt, dass ihre Zentrierfinger 26 nicht mehr in Freiräume 60 zwischen den Probengefäßen 52 eingreifen können. Stattdessen sitzen die Zentrierfinger 26 oberseitig auf den Probengefäßen 52 auf. Entsprechend ist die Zentriervorrichtung 14 auf einer Vertikalposition 54 oberhalb der Zielposition 56 stehen geblieben (Fall iii.).

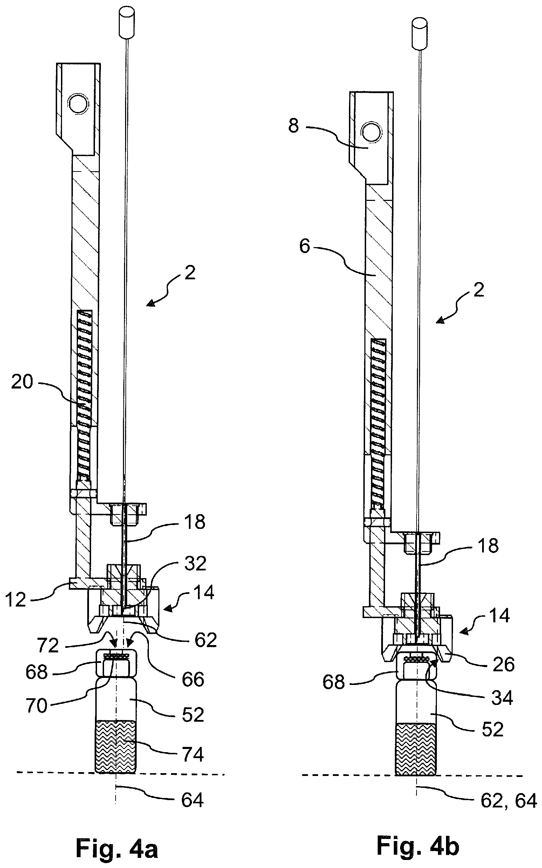

Die **Figur 4a** zeigt eine schematische Seitenansicht einer geschnitten dargestellten, erfindungsgemäßen Pipettiervorrichtung 2 oberhalb eines Probengefäßes 52 vor einem Pipettiervorgang. Eine Endplatte 12 mit einer Zentriervorrichtung 14 wird von einer Feder 20 nach unten in eine Ruheposition gedrückt, so dass ein freies Ende 32 einer Hilfskanüle 18 von der Zentriervorrichtung 14 umschlossen ist. Eine Mittelachse 62 der Zentriervorrichtung 14 entspricht dabei einer Längsachse der Hilfskanüle 18. Das Probengefäß 52 ist hier derart unterhalb der Zentriervorrichtung 14 angeordnet, dass eine Gefäßachse 64 gegenüber der Mittelachse 62 seitlich versetzt ist. Die Mittelachse 62 der Hilfskanüle 18 weist hier auf eine Oberseite 66 eines Deckels 68 des Probengefäßes 52. Der Deckel 68 verschließt das Probengefäß 52 mit einem Septum 70, das unterhalb einer zentralen Öffnung 72 in dem Deckel angeordnet ist. In dem Probengefäß 52 befindet sich eine Probenflüssigkeit 74.

Die **Figur 4b** zeigt die Pipettiervorrichtung 2 und das Probengefäß 52 von Fig. 4a, wobei nun die Zentriervorrichtung 14 auf dem Probengefäß 52 aufsitzt. Die Zentriervorrichtung 14 wurde zunächst durch Absenken einer oberen Aufhängung 8 eines Führungsarms 6 der Pipettiervorrichtung 2 dem Probengefäß 52 so weit angenähert, dass Zentrierfinger 26 der Zentriervorrichtung 14 das Probengefäß 52 von außen umgreifen konnten. Beim weiteren Absenken trat der Deckel 68 des Probengefäßes 52 mit den konischen Abschrägungen 34 der Zentrierfinger 26 in Kontakt. Das Probengefäß 52 wurde dabei von der Zentriervorrichtung 14 so ausgerichtet, dass nun die Gefäßachse 64 mit der Mittelachse 62 der Zentriervorrichtung 14 und der mit dieser identischen Längsachse der Hilfskanüle 18 zusammenfällt.

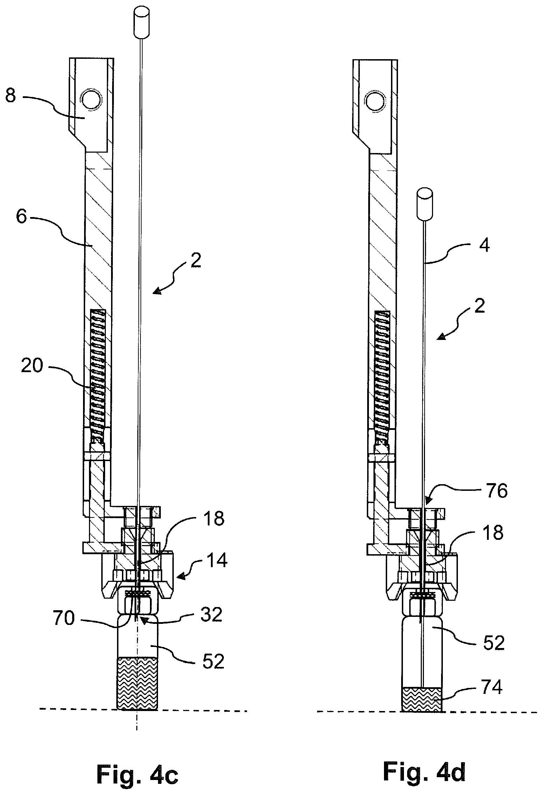

Die **Figur 4c** zeigt die Pipettiervorrichtung 2 von Fig. 4a, 4b, wobei die obere Aufhängung 8 des Führungsarms 6 gegenüber dem Zustand von Fig. 4b noch weiter abgesenkt wurde. Das freie Ende 32 der Hilfskanüle 18 hat dadurch das Septum 70 des Probengefäßes 52 durchstochen. Die Zentriervorrichtung 14 wird durch die komprimierte Feder 20 auf das Probengefäß 52 gedrückt. Durch die Zentriervorrichtung 14 wurde bewirkt, dass die Hilfskanüle 18 das Septum 70 genau mittig durchstochen hat.

Die **Figur 4d** zeigt die Pipettiervorrichtung 2 von Fig. 4a - 4c, wobei gegenüber Fig. 4c nun eine Pipettiernadel in 4 das Probengefäß 52 eingeführt wurde. Die Pipettiernadel 4 wurde dazu axial durch die Hilfskanüle 18 hindurchgeführt. Zwischen der Pipettiernadel 4 und der Hilfskanüle 18 ist dabei ein Belüftungskanal 76 ausgebildet, indem eine Außenfläche der Pipettiernadel 4 von einer Innenfläche der Hilfskanüle 18 beabstandet angeordnet ist. Ein Außendurchmesser der Pipettiernadel 4 ist dazu ca. 10 % kleiner als ein Innendurchmesser der Hilfskanüle 18 gewählt. Die Pipettiernadel 4 wurde so weit vorgeschoben, dass sie in die Probenflüssigkeit 74 eingetaucht ist. Sodann wurde Probenflüssigkeit 74 in die Pipettiernadel 4 eingesaugt.

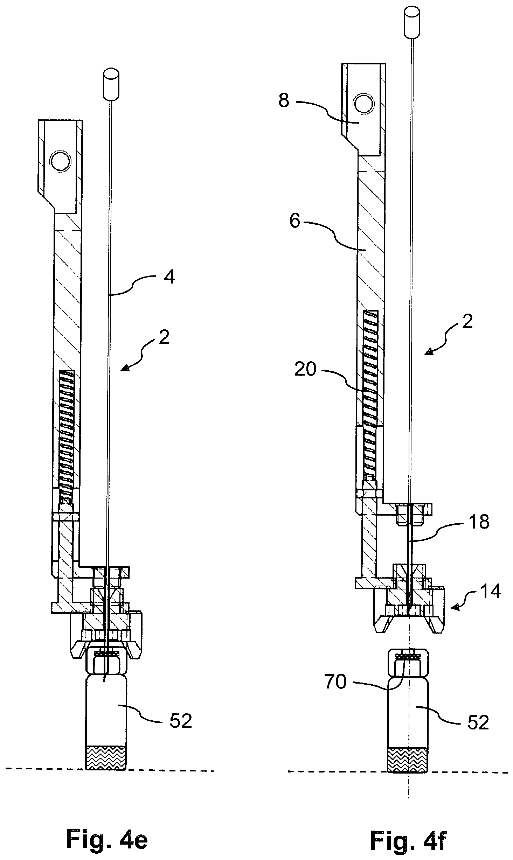

Die **Figur 4e** zeigt die Pipettiervorrichtung 2 von Fig. 4a - 4d, wobei gegenüber Fig. 4d die Pipettiernadel 4 mit eingesaugter Probenflüssigkeit nach oben aus dem Probengefäß 52 herausgezogen wurde.

Die **Figur 4f** zeigt die Pipettiervorrichtung 2 von Fig. 4a - 4e, wobei nun die Hilfskanüle 18 aus dem Septum 70 herausgezogen ist und die Zentriervorrichtung 14 von dem Probengefäß 52 abgehoben ist. Beim Anheben der oberen Aufhängung 8 des Führungsarms 6 wurde zunächst die Hilfskanüle 18 aus dem Septum 70 herausgezogen. Die Zentriervorrichtung 14 wurde währenddessen noch von der Feder 20 gegen das Probengefäß 52 gedrückt. Nachdem die Zentriervorrichtung 14 ihre Ruheposition relativ zu der oberen Aufhängung 8 erreicht hatte, wurde auch die Zentriervorrichtung 14 beim weiteren Anheben der oberen Aufhängung 8 von dem Probengefäß 52 nach oben hin entfernt. Der Pipettiervorgang ist damit beendet.

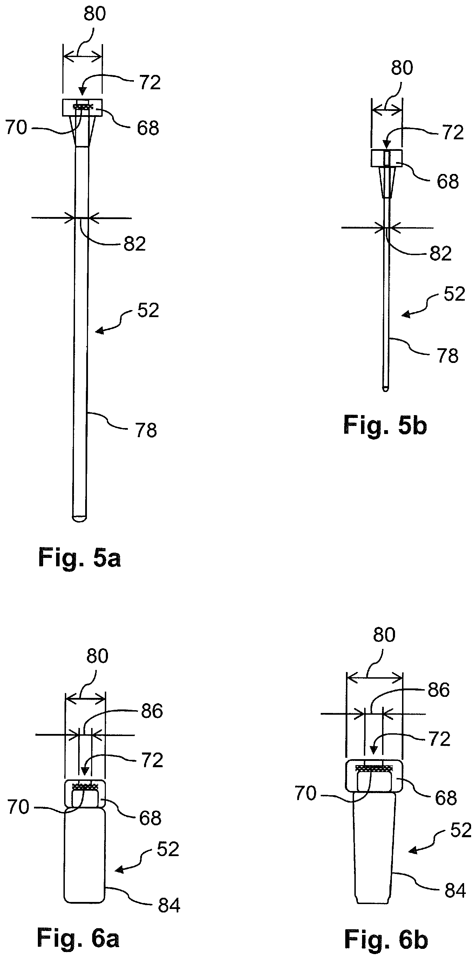

Die **Figur 5a** zeigt eine erste Ausführungsform eines sehr dünnen Probengefäßes 52 für eine erfindungsgemäße Pipettiervorrichtung (nicht dargestellt). Das Probengefäß 52 ist hier als ein erstes NMR-Röhrchen (NMR-Probengefäß) mit einem Außendurchmesser von mehr als 2,5 mm und einer Länge größer 150 mm ausgebildet. Das Probengefäß 52 umfasst einen im Wesentlichen hohlzylindrischen Korpus 78 und einen Deckel 68. In dem Deckel 68 ist eine zentrale Öffnung 72 ausgebildet, die von einem Septum 70 verschlossen wird. Ein Außendurchmesser 80 des Deckels 68 beträgt hier ca. 8 mm. Ein Innendurchmesser 82 des Korpus 78 entspricht einem Öffnungsdurchmesser der Öffnung 72 und beträgt hier ca. 2,5 mm.

Die **Figur 5b** zeigt eine zweite Ausführungsform eines sehr dünnen Probengefäßes 52 für eine erfindungsgemäße Pipettiervorrichtung (nicht dargestellt). Das Probengefäß 52 ist hier als ein zweites NMR-Röhrchen (NMR-Probengefäß) mit einem Außendurchmesser von weniger als 2,5 mm und einer Länge kleiner 150 mm ausgebildet. Die zweite Ausführungsform des Probengefäßes 52 von Fig. 5b entspricht im grundsätzlichen Aufbau der ersten Ausführungsform von Fig. 5a. Ein Außendurchmesser 80 eines Deckels 68 beträgt hier jedoch nur ca. 6 mm. Ein Innendurchmesser 82 eines im Wesentlichen hohlzylindrischen Korpus 78 entspricht hier einem Öffnungsdurchmesser einer zentralen Öffnung 72 in dem Deckel 68 und beträgt hier ca. 1,0 mm.

Die **Figur 6a** zeigt eine dritte Ausführungsform eines Probengefäßes 52 für eine erfindungsgemäße Pipettiervorrichtung (nicht dargestellt). Das Probengefäß 52 ist hier als eine Auto-Sampler-Probenflasche ausgebildet. Das Probengefäß 52 umfasst einen Flaschenkorpus 84 und einen Deckel 68. In dem Deckel 68 ist eine zentrale Öffnung 72 ausgebildet, die von einem Septum 70 verschlossen wird. Ein Außendurchmesser 80 des Deckels 68 beträgt hier ca. 11 mm. Ein Öffnungsdurchmesser 86 der zentralen Öffnung 72 in dem Deckel 68 beträgt hier ca. 3 mm.

Die **Figur 6b** zeigt eine vierte Ausführungsform eines Probengefäßes 52 für eine erfindungsgemäße Pipettiervorrichtung (nicht dargestellt). Das Probengefäß 52 ist hier als eine Cryo-Vial-Probenflasche ausgebildet. Das Probengefäß 52 umfasst einen Flaschenkorpus 84 und einen Deckel 68. Der Flaschenkorpus 84 ist hier konisch (nach unten zulaufend) ausgebildet. In dem Deckel 68 ist eine zentrale Öffnung 72 ausgebildet, die von einem Septum 70 verschlossen wird. Ein Außendurchmesser 80 des Deckels 68 beträgt hier ca. 14mm. Ein Öffnungsdurchmesser 86 der zentralen Öffnung 72 in dem Deckel 68 beträgt hier ca. 4 mm.

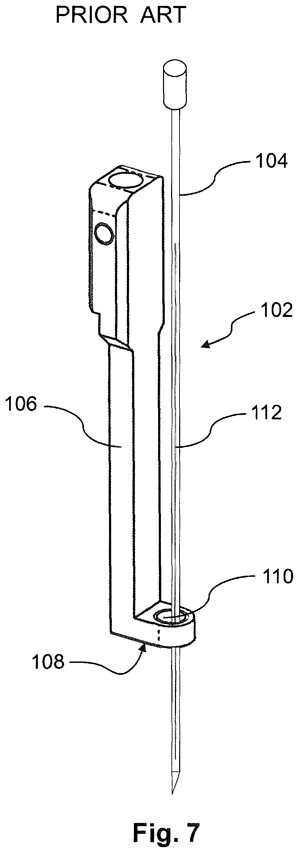

Die **Figur 7** zeigt eine Pipettiervorrichtung 102 mit einer frei hängenden Septum-Piercing-Nadel 104 aus dem Stand der Technik. Die Septum-Piercing-Nadel 104 wird bei dieser Pipettiervorrichtung 102 aus dem Stand der Technik sowohl zum Durchstechen eines Septums eines Probengefäßes (nicht dargestellt) als auch zum Ansaugen von Probenflüssigkeit aus dem Probengefäß verwendet. Die Pipettiervorrichtung 102 umfasst neben der Septum-Piercing-Nadel 104 einen Führungsarm 106. An dem Führungsarm 106 ist unterseitig eine Niederhalteeinrichtung 108 ausgebildet. Die Septum-Piercing-Nadel 104 durchragt eine Ausnehmung 110, die an der Niederhalteausrichtung 108 ausgebildet ist, ohne in der Ausnehmung 110 geführt oder abgestützt zu werden. Eine außenseitige Längsgravur 112 der Septum-Piercing-Nadel 104 dient zur Belüftung des Probengefäßes, wenn die Septum-Piercing-Nadel 104 durch das Septum des Probengefäßes gestochen ist.

## Patentansprüche

1. Pipettiervorrichtung (2) zur Entnahme von Probenflüssigkeit aus einem Probengefäß (52), das oberseitig mit einem Septum (70) verschlossen ist, umfassend eine Pipettiernadel (4) sowie eine Hilfskanüle (18) zum Durchstechen des Septums (70), die zum axialen Durchführen der Pipettiernadel (4) durch die Hilfskanüle (18) ausgebildet ist,
wobei die Pipettiervorrichtung (2) einen Führungsarm (6) umfasst, an dessen unterem Ende (10) eine Endplatte (12) angeordnet ist, die entlang des Führungsarms (6) gegen einen federnden Widerstand axial verschiebbar ist,
und wobei die Pipettiervorrichtung (2) eine Zentriervorrichtung (14) aufweist, die in die Endplatte (12) des Führungsarms (6) einsetzbar ist, **dadurch gekennzeichnet dass** radial außen in Umfangsrichtung um die Zentriervorrichtung (14) verteilt mindestens drei Zentrierfinger (26) mit konischen Abschrägungen (34) ausgebildet sind, die eine Niederhalteeinrichtung für das Probengefäß (52) bilden und im Betrieb das Probengefäß (52) oberseitig von außen umgreifen können,
und dass die Zentriervorrichtung (14) zwischen den Zentrierfingern (26) kreissegmentförmige Einbuchtungen (46) aufweist, sodass die Zentrierfinger (26) in Freiräume zwischen nebeneinander stehenden Probengefäßen (52) hinein ragen können, während die Einbuchtungen (46) zwischen den benachbarten Probengefäßen (52) angeordnet sind.

2. Pipettiervorrichtung (2) nach Anspruch 1, **dadurch gekennzeichnet, dass** die Zentriervorrichtung (14) in die Endplatte (12) einschraubbar ist.

3. Pipettiervorrichtung (2) nach Anspruch 1, **dadurch gekennzeichnet, dass** die Zentriervorrichtung (14) in die Endplatte (12) einrastbar, einklemmbar oder mittels eines Bajonettverschlusses einsetzbar ist.

4. Pipettiervorrichtung (2) nach einem der vorhergehenden Ansprüche, **dadurch gekennzeichnet, dass** eine Verdrehsicherung (28) vorgesehen ist, die so ausgebildet, dass sie eine definierte Ausrichtung der Zentriervorrichtung (14) relativ zur Endplatte (12) ermöglicht, wobei die Verdrehsicherung (28) insbesondere wenigstens zwei, bevorzugt vier, oberseitige Vorsprünge (30) der Zentriervorrichtung (14) aufweist, die die Endplatte (12) seitlich umgreifen.

5. Pipettiervorrichtung (2) nach einem der vorhergehenden Ansprüche, **dadurch gekennzeichnet, dass** die Zentriervorrichtung (14) unterseitig eine koaxial zur Hilfskanüle (18) angeordnete, vorzugsweise ringförmige Abhebehilfseinrichtung (42) aufweist.

6. Pipettiervorrichtung (2) nach einem der vorhergehenden Ansprüche, **dadurch gekennzeichnet, dass** zwischen der Hilfskanüle (18) und der Pipettiernadel (4) ein Belüftungskanal (76) für das Probengefäß (52) eingerichtet ist, wenn die Pipettiernadel (4) axial durch die Hilfskanüle (18) durchgeführt ist.

7. Pipettiervorrichtung (2) nach einem der vorhergehenden Ansprüche, **dadurch gekennzeichnet, dass** die Zentrierfinger (26) der Zentriervorrichtung (14) unterseitig in Umfangsrichtung der Zentriervorrichtung (14) abgeschrägt sind.

8. Pipettiervorrichtung (2) nach einem der vorhergehenden Ansprüche, **dadurch gekennzeichnet, dass** die Zentrierfinger (26) gleichmäßig über den Umfang der Zentriervorrichtung (14) verteilt angeordnet sind.

9. Pipettiervorrichtung (2) nach einem der vorhergehenden Ansprüche, **dadurch gekennzeichnet, dass** die Zentriervorrichtung (14) vier jeweils paarweise gegenüberliegend angeordnete Zentrierfinger (26) aufweist.

10. Pipettiervorrichtung (2) nach einem der vorhergehenden Ansprüche, **dadurch gekennzeichnet, dass** die Zentriervorrichtung (14) auch ohne Werkzeug in die Endplatte (12) des Führungsarms (6) einsetzbar und aus der Endplatte (12) ausbaubar ist.

11. Verfahren zum Detektieren des Vorhandenseins und gegebenenfalls der Position eines Probengefäßes (52) mittels einer Pipettiervorrichtung (2) nach einem der vorhergehenden Ansprüche, umfassend folgende Schritte:
a) Festlegen einer vertikalen Zielposition (56) für die Zentriervorrichtung (14),
b) Absenken der Zentriervorrichtung (14) am Führungsarm (6) unter Überwachung einer aktuellen Vertikalposition (54) der Zentriervorrichtung (14), bis ein Widerstand dem weiteren Absenken entgegen wirkt oder bis die Zentriervorrichtung (14) eine vordefinierte Tiefstposition (58) erreicht hat,
c) Auswerten der in Schritt b) erreichten Vertikalposition (54) der Zentriervorrichtung (14), wobei
i. eine Vertikalposition (54) unterhalb der Zielposition (56) bedeutet, dass kein Probengefäß (52) gefunden wurde,
ii. eine Vertikalposition (54), die der Zielposition (56) entspricht, bedeutet, dass die Zentriervorrichtung (14) auf einem Probengefäß (52) zentriert ist,
iii. eine Vertikalposition (54) oberhalb der Zielposition (56) bedeutet, dass die Zentriervorrichtung (14) auf einem Probengefäß (52) aufreitet, ohne zentriert zu sein.

12. Verfahren zum Entnehmen von Probenflüssigkeit (74) aus einem Probengefäß (52) mit einer Pipettiervorrichtung (2) nach einem der Ansprüche 1 bis 10, wobei zunächst das Verfahren zum Detektieren eines Probengefäßes (52) nach Anspruch 11 durchgeführt wird, und wobei in den Fällen i. und iii. das Entnahmeverfahren abgebrochen wird und nur im Fall ii. weiterhin die folgenden Schritte durchgeführt werden:
d) weiteres Absenken einer oberseitigen Aufhängung (8) des Führungsarms (6) gegen den federnden Widerstand, so dass die Hilfskanüle (18) das Septum (70) des Probengefäßes (52) penetriert,
e) axiales Durchführen der Pipettiernadel (4) durch die Hilfskanüle (18) in das Probengefäß (52) hinein,
f) Absaugen von Probenflüssigkeit (74) aus dem Probengefäß (52) in die Pipettiernadel (4),
g) Herausziehen der Pipettiernadel (4) aus dem Probengefäß (52),
h) Anheben der oberseitigen Aufhängung (8) des Führungsarms (6) bis die Hilfskanüle (18) aus dem Septum (70) herausgezogen ist, wobei die Niederhalteeinrichtung gegen die Oberseite (66) des Probengefäßes (52) drückt,
i) weiteres Anheben der oberseitigen Aufhängung (8) des Führungsarms (6), so dass sich die Zentriervorrichtung (14) von dem Probengefäß (52) löst.

## Claims

1. A pipetting device (2) for removing sample fluid from a sample vessel (52) that is sealed on the top side with a septum (70), comprising a pipetting needle (4) as well as an auxiliary cannula (18) for piercing the septum (70), designed to guide the pipetting needle (4) axially through the auxiliary cannula (18),
wherein
the pipetting device (2) comprises a guide arm (6) on the lower end (10) of which is arranged an end plate (12) that is axially displaceable along the guide arm (6) against a resilient resistance,
and wherein the pipetting device (2) comprises a centering device (14) that can be inserted into the end plate (12) of the guide arm (6),
**characterized in that**
at least three centering fingers (26) with conical bevels (34) are constructed on the radial outside of the centering device (14), distributed around the circumference thereof, forming a holding-down device for the sample vessel (52) and being able to engage around the top of the sample vessel (52) from the outside during operation,
and that the centering device (14) has circular-segment-shaped indentations (46) between the centering fingers (26) such that the centering fingers (26) can project into free spaces between neighboring sample vessels (52) while the indentations (46) are arranged between the neighboring sample vessels (52).

2. The pipetting device (2) according to claim 1, **characterized in that** the centering device (14) can be screwed into the end plate (12).

3. The pipetting device (2) according to claim 1, **characterized in that** the centering device (14) can be snapped into, clamped into, or inserted by means of a bayonet socket into the end plate (12).

4. The pipetting device (2) according to any one of the preceding claims, **characterized in that** an anti-twist device (28) is provided that is designed such that it enables a defined alignment of the centering device (14) relative to the end plate (12), with the anti-twist device (28) having particularly at least two, preferably four, top-side projections (30) of the centering device (14) that engage laterally around the end plate (12).

5. The pipetting device (2) according to any one of the preceding claims, **characterized in that** the centering device (14) has on its bottom side a preferably annular lift-off aid (42) arranged coaxially to the auxiliary cannula (18).

6. The pipetting device (2) according to any one of the preceding claims, **characterized in that** a ventilation channel (76) is established for the sample vessel (52) between the auxiliary cannula (18) and the pipetting needle (4) when the pipetting needle (4) passes axially through the auxiliary cannula (18).

7. The pipetting device (2) according to any one of the preceding claims, **characterized in that** the centering fingers (26) of the centering device (14) are beveled on the bottom side in the circumferential direction of the centering device (14).

8. The pipetting device (2) according to any one of the preceding claims, **characterized in that** the centering fingers (26) are arranged so as to be distributed uniformly over the periphery of the centering device (14).

9. The pipetting device (2) according to any one of the preceding claims, **characterized in that** the centering device (14) has four centering fingers (26) arranged in opposing pairs.

10. The pipetting device (2) according to any one of the preceding claims, **characterized in that** the centering device (14) can also be inserted into the end plate (12) of the guide arm (6) and removed from the end plate (12) without a tool.

11. A method for detecting the presence and, optionally, the position of a sample vessel (52) by means of a pipetting device (2) according to any one of the preceding claims, comprising the following steps:
a. establishing a vertical target position (56) for the centering device (14);
b. lowering the centering device (14) on the guide arm (6) while monitoring a current vertical position (54) of the centering device (14) until a resistance counteracts further lowering or until the centering device (14) has reached a predefined lowest position (58);
c. evaluating the vertical position (54) of the centering device (14) reached in step b),
i. with a vertical position (54) below the target position (56) meaning that no sample vessel (52) was found,
ii. with a vertical position (54) that corresponds to this target position (56) meaning that the centering device (14) is centered on a sample vessel (52), and
iii. with a vertical position (54) above this target position (56) meaning that the centering device (14) is located on a sample vessel (52) but is not centered.

12. A method for removing sample fluid (74) from a sample vessel (52) using a pipetting device (2) according to any one of claims 1 to 10, wherein the method for detecting a sample vessel (52) according to claim 11 is first carried out, and wherein the removal process is aborted in cases i. and iii., and the following steps are furthermore carried out only in case ii.:
d) further lowering a top-side suspension (8) of the guide arm (6) against the resilient resistance, so that the auxiliary cannula (18) pierces the septum (70) of the sample vessel (52);
e) axially guiding the pipetting needle (4) through the auxiliary cannula (18) into the sample vessel (52);
f) aspirating sample fluid (74) out of the sample vessel (52) into the pipetting needle (4);
g) pulling out the pipetting needle (4) from the sample vessel (52);
h) lifting the top-side suspension (8) of the guide arm (6) until the auxiliary cannula (18) has been pulled out of the septum (70), the holding-down device pressing against the top side (66) of the sample vessel (52); and
i) further lifting the top-side suspension (8) of the guide arm (6), whereby the centering device (14) detaches from the sample vessel (52).

## Revendications

1. Dispositif de pipetage (2) dévolu au prélèvement de liquide d'échantillonnage hors d'un réceptacle (52) d'échantillons obturé par un septum (70) à la face supérieure, comprenant une aiguille de pipetage (4), ainsi qu'une canule auxiliaire (18) destinée à perforer ledit septum (70) et conçue en vue du passage axial de ladite aiguille de pipetage (4) parcourant ladite canule auxiliaire (18),
sachant que le dispositif de pipetage (2) est muni d'un bras de guidage (6), à l'extrémité inférieure (10) duquel se trouve une platine d'extrémité (12) pouvant être déplacée axialement le long dudit bras de guidage (6), en opposition à une résistance élastique,
et sachant que ledit dispositif de pipetage (2) est pourvu d'un dispositif de centrage (14) pouvant être inséré dans ladite platine d'extrémité (12) dudit bras de guidage (6), **caractérisé par le fait**
**qu'**au moins trois doigts de centrage (26) radialement répartis à l'extérieur autour du dispositif de centrage (14), dans la direction périphérique, sont dotés de biseaux coniques (34), forment un système de maintien à demeure affecté au réceptacle (52) d'échantillons et peuvent, en service, ceinturer ledit réceptacle (52) d'échantillons depuis l'extérieur, à la face supérieure ;
et par le fait que ledit dispositif de centrage (14) comporte des renfoncements (46) en forme de segments circulaires, entre les doigts de centrage (26), de sorte que lesdits doigts de centrage (26) peuvent pénétrer dans des espaces libres entre des réceptacles (52) d'échantillons placés en juxtaposition, tandis que lesdits renfoncements (46) sont interposés entre les réceptacles (52) d'échantillons occupant des positions voisines.

2. Dispositif de pipetage (2) selon la revendication 1, **caractérisé par le fait que** le dispositif de centrage (14) peut être vissé dans la platine d'extrémité (12).

3. Dispositif de pipetage (2) selon la revendication 1, **caractérisé par le fait que** le dispositif de centrage (14) peut être encliqueté ou coincé dans la platine d'extrémité (12), voire y être inséré au moyen d'une fermeture à baïonnette.

4. Dispositif de pipetage (2) selon l'une des revendications précédentes, **caractérisé par le fait qu'**il est prévu un verrouillage antirotation (28) réalisé de manière à permettre une orientation bien définie du dispositif de centrage (14), par rapport à la platine d'extrémité (12), ledit verrouillage antirotation (28) comportant, en particulier, au moins deux, de préférence quatre protubérances supérieures (30) dudit dispositif de centrage (14) qui ceinturent latéralement ladite platine d'extrémité (12).

5. Dispositif de pipetage (2) selon l'une des revendications précédentes, **caractérisé par le fait que** le dispositif de centrage (14) est pourvu, à la face inférieure, d'un système de soulèvement auxiliaire (42), de préférence annulaire, qui est disposé coaxialement par rapport à la canule auxiliaire (18).

6. Dispositif de pipetage (2) selon l'une des revendications précédentes, **caractérisé par le fait qu'**un canal de ventilation (76) dédié au réceptacle (52) d'échantillons est ménagé, entre la canule auxiliaire (18) et l'aiguille de pipetage (4), lorsque ladite aiguille de pipetage (4) est engagée axialement par ladite canule auxiliaire (18).

7. Dispositif de pipetage (2) selon l'une des revendications précédentes, **caractérisé par le fait que** les doigts de centrage (26) du dispositif de centrage (14) sont biseautés, à la face inférieure, dans la direction périphérique dudit dispositif de centrage (14).

8. Dispositif de pipetage (2) selon l'une des revendications précédentes, **caractérisé par le fait que** les doigts de centrage (26) occupent des emplacements uniformément répartis sur le pourtour du dispositif de centrage (14).

9. Dispositif de pipetage (2) selon l'une des revendications précédentes, **caractérisé par le fait que** le dispositif de centrage (14) compte quatre doigts de centrage (26), agencés en vis-à-vis par paires respectives.

10. Dispositif de pipetage (2) selon l'une des revendications précédentes, **caractérisé par le fait que** le dispositif de centrage (14) peut, également en l'absence d'outil, être inséré dans la platine d'extrémité (12) du bras de guidage (6) et être extrait de ladite platine d'extrémité (12).

11. Procédé conçu pour détecter la présence et, le cas échéant, l'emplacement d'un réceptacle (52) d'échantillons au moyen d'un dispositif de pipetage (2) conforme à l'une des revendications précédentes, incluant les étapes suivantes :
a) consignation d'un emplacement vertical ciblé (56), assigné au dispositif de centrage (14),
b) abaissement dudit dispositif de centrage (14) sur le bras de guidage (6), avec surveillance d'un emplacement vertical effectif (54) dudit dispositif de centrage (14), jusqu'à ce qu'une résistance agisse en opposition à une poursuite de l'abaissement, ou jusqu'à ce que ledit dispositif de centrage (14) ait atteint un emplacement prédéfini (58) occupant la position la plus basse,
c) évaluation de l'emplacement vertical (54) du dispositif de centrage (14), atteint à l'étape b), sachant
i. qu'un emplacement vertical (54) au-dessous de l'emplacement ciblé (56) signifie qu'aucun réceptacle (52) d'échantillons n'a été trouvé,
ii. qu'un emplacement vertical (54) correspondant audit emplacement ciblé (56) signifie que le dispositif de centrage (14) est centré sur un réceptacle (52) d'échantillons,
iii. qu'un emplacement vertical (54) au-dessus dudit emplacement ciblé (56) signifie que ledit dispositif de centrage (14) chevauche un réceptacle (52) d'échantillons, sans être centré.

12. Procédé conçu pour prélever du liquide d'échantillonnage (74) hors d'un réceptacle (52) d'échantillons à l'aide d'un dispositif de pipetage (2) conforme à l'une des revendications 1 à 10, sachant que le procédé conforme à la revendication 11, dévolu à la détection d'un réceptacle (52) d'échantillons, est mis en œuvre dans un premier temps, sachant que le procédé de prélèvement est interrompu dans les cas i. et iii. et sachant, par ailleurs, que les étapes suivantes sont exécutées uniquement dans le cas ii. :
d) poursuite de l'abaissement d'une suspension (8) située en partie haute du bras de guidage (6), en opposition à la résistance élastique, de façon telle que la canule auxiliaire (18) transperce le septum (70) du réceptacle (52) d'échantillons,
e) engagement axial, dans ledit réceptacle (52) d'échantillons, de l'aiguille de pipetage (4) parcourant ladite canule auxiliaire (18),
f) aspiration de liquide d'échantillonnage (74) dans ladite aiguille de pipetage (4) à partir dudit réceptacle (52) d'échantillons,
g) extraction de ladite aiguille de pipetage (4) hors dudit réceptacle (52) d'échantillons,
h) soulèvement de ladite suspension (8) située en partie haute du bras de guidage (6), jusqu'à ce que ladite canule auxiliaire (18) soit extraite dudit septum (70), le système de maintien à demeure exerçant alors une pression contre la face supérieure (66) dudit réceptacle (52) d'échantillons,
i) poursuite du soulèvement de ladite suspension (8) située en partie haute dudit bras de guidage (6), de telle sorte que le dispositif de centrage (14) se dissocie d'avec ledit réceptacle (52) d'échantillons.
